# EUROPEAN PATENT APPLICATION

(11) **EP 2 040 290 A1**
(43) Date of publication of application: **25.03.2009**
(21) Application number: 07018642.4
(22) Date of filing: 21.09.2007
(51) Int. Cl.: H01L 21/677, B65G 25/02

(54) **Supporting device, substrate transportation equipment and related method thereof**

(71) Applicant: Motech Industries Inc., Shen-Keng Taipei Hsien (TW)
(72) Inventor: Chang, Shun-Chu, East District Hsinchu City (TW)
(74) Representative: Hager, Thomas Johannes

(57) **Abstract**

A supporting device (200) includes a support body (210) for supporting a substrate (330) and an auxiliary wing (220) for supporting the corner of the substrate (330), so that the substrate (330) is substantially horizontally disposed on the supporting device (200). Also disclosed is a substrate transportation equipment (300) including the supporting device (200) and a movable protruding member (344). The substrate transportation equipment (200) can prevent the movable protruding member (344) from hitting the edge of the substrate (330) when the movable protruding member (344) moves.

## Description

The present invention relates to a supporting device, a substrate transportation equipment and a method for transporting a substrate, according to the pre-characterizing clauses of claims 1, 1 and 21 respectively.

In current solar cell production, transportation equipment is employed to transport the solar cells. During this time, however, the edges of the solar cells may droop and bend due to various reasons, such as curling of the substrate because of heated aluminum paste on the back of the substrate or because the substrate is extremely thin. Once the substrates bend beyond a certain degree, they will collide with one another and pile up during transportation. This collision causes the yield to drop.

This in mind, the present invention aims at providing a supporting device with an auxiliary wing for supporting corners of a substrate so that the substrate may be substantially horizontally disposed on the supporting device.

This is achieved by a supporting device according to claim 1. The dependent claims pertain to corresponding further developments and improvements.

As will be seen more clearly from the detailed description below, the claimed supporting device includes a supporting device with an auxiliary wing for supporting corners of a substrate so that the substrate may be substantially horizontally disposed on the supporting device.

Additionally, the present invention aims at providing a substrate transportation equipment in which a supporting device includes a support body and an auxiliary wing supporting corners of a substrate so that the substrate may be substantially horizontally disposed on the supporting device.

This is achieved by a substrate transportation equipment according to claim 11. The dependent claims pertain to corresponding further developments and improvements.

As will be seen more clearly from the detailed description below, the claimed substrate transportation equipment includes a support body and an auxiliary wing supporting corners of a substrate so that the substrate may be substantially horizontally disposed on the supporting device.

In addition, the present invention aims at providing a method for transporting a substrate, wherein a supporting device including a support body and an auxiliary wing is provided so as to make the corners of the substrate lie substantially horizontally on the auxiliary wing.

This is achieved by a method for transporting a substrate according to claim 21. The dependent claims pertain to corresponding further developments and improvements.

As will be seen more clearly from the detailed description below, the claimed method of transporting a substrate includes providing a supporting device with a support body and an auxiliary wing so that the corners of the substrate may lie substantially horizontally on the auxiliary wing.

In the following, the invention is further illustrated by way of example, taking reference to the accompanying drawings. Thereof:
- FIG. 1: illustrates the conventional transportation of the substrates;
- FIG. 2: illustrates the supporting device of the present invention;
- FIG. 3: illustrates the substrate transportation equipment of the present invention; and
- FIGS. 4-7: illustrate the method for transporting a substrate of the present invention.

One aspect of the present invention provides a supporting device and a substrate transportation equipment to prevent the working beam from colliding with the substrate on the base so as to effectively lower the defects and increase the yield.

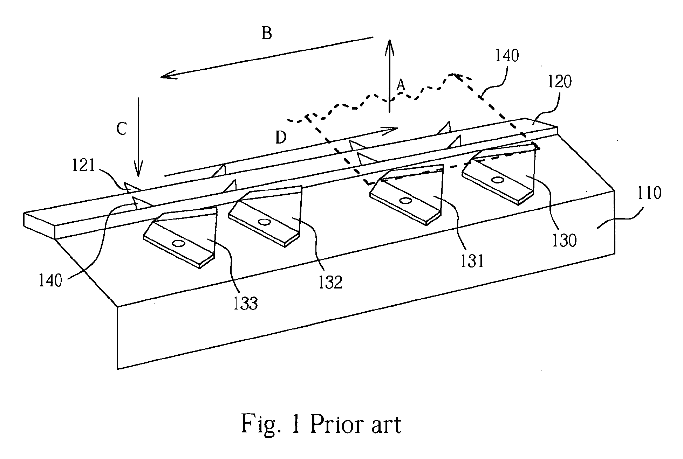

FIG. 1 illustrates the conventional transportation of the substrates. The transportation equipment 100 includes a base 110, a walking beam 120 and cell seats 130, 131, 132, 133. The cell seats 130, 131, 132, 133 are fixed on the base 110. The walking beam 120 includes multiple protruding members 121 between the cell seats 130, 131 and the cell seats 132, 133 to transport the substrate 140.

A complete cycle of the walking beam 120 includes movements A-B-C-D. When the substrate bends, the far edges droop more than the ordinary ones. If the walking beam 120 moves along the D direction, the protruding members 121 of the walking beam 120 collide with the drooping edges of the substrate 140 on the cell seats 132, 133 and cause pile-ups. The yield therefore decreases.

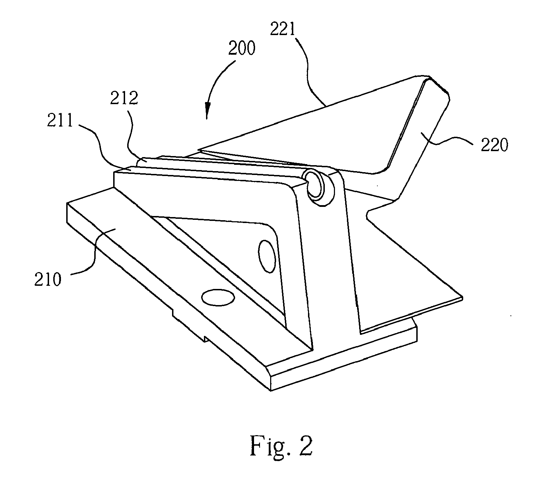

FIG. 2 illustrates the supporting device 200 of the present invention. The supporting device 200 includes a support body 210 and an auxiliary wing 220. The support body 210 is utilized for supporting a substrate (not shown) and the auxiliary wing 220 is utilized for supporting the corners of the substrate, so that the substrate is substantially horizontally disposed on the supporting device 200.

Usually the support body 210 includes a first top surface 211 so that the substrate may lie on the first top surface 211. Preferably, the support body 210 further includes a cushion 212, made of elastic material, on the first top surface 211. Similarly, the auxiliary wing 220 may include a second top rim 221 so that the corners of the substrate may be disposed on the second top rim 221 of the auxiliary wing 220. Also, the auxiliary wing 220 may further include a pad on the second top rim 221 to avoid scratching the substrate. The auxiliary wing 220 may be made of materials such as plastics or metal, so that the auxiliary wing 220 can be adjusted manually to correctly support the corners of the substrate.

The auxiliary wing 220 can extend from the support body 210 along the diagonal direction of the substrate. According to one preferred embodiment of the present invention, the auxiliary wing 220 is detachably connected to the support body 210. According to another preferred embodiment of the present invention, the support body 210 and the auxiliary wing 220 are formed as an integrated unit. Preferably, the auxiliary wing 220 is a bended metal plate latched to a base with the support body 210.

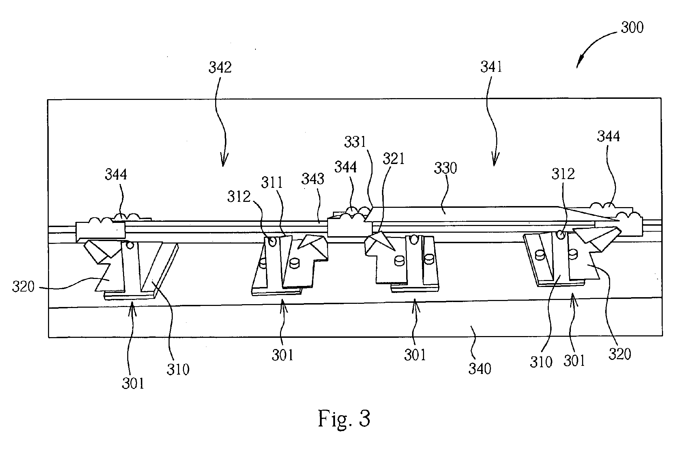

FIG. 3 illustrates the substrate transportation equipment 300 of the present invention. The substrate transportation equipment 300 includes a base 340 and a plurality of supporting devices 301. The base 340 includes a central working beam 343, a first base surface 341 and a second base surface 342. The first base surface 341 and the second base surface 342 are respectively disposed on both sides of the central working beam 343. The central working beam 343 includes a reciprocating movable protruding member 344 for transporting a substrate 330.

The supporting devices 301 which are correspondingly disposed on the first base surface 341 and the second base surface 342 respectively include a support body 310 and an auxiliary wing 320. The support body 310 is utilized for supporting the substrate 330 and the auxiliary wing 320 is utilized for supporting the substrate 330 so that the substrate 330 may be substantially horizontally disposed on the supporting devices 301. Because the substrate 330 can be substantially horizontally disposed on the supporting devices 301, the collision of the movable protruding member 344 with corners 331 of the substrate 330 during its reciprocation can be avoided.

The substrate 330 can be, but is not limited to, a bendable article, such as a solar cell. Usually, the support body 310 includes a first top surface 311 so that the substrate 330 may lie on the support body 310 by means of the first top surface 311. Preferably, the support body 310 further includes a cushion 312 made of elastic material, such as a plastic tube, on the first top surface 311. Similarly, the auxiliary wing 320 may include a second top rim 321 so that the corners 331 of the substrate 330 lie on the second top rim 321 of the auxiliary wing 320. Also, the auxiliary wing 320 may further include a pad (not shown) on the second top rim 321 to avoid scratching the substrate. The auxiliary wing 320 may be made of materials such as plastics or metal, so that the auxiliary wing 320 can correctly support the corners 331 of the substrate 330.

The auxiliary wing 320 may extend from the support body 310 along the diagonal direction of the substrate 330. The auxiliary wing 320 may be detachably connected to the support body 310, or the support body 310 and the auxiliary wing 320 may be formed as an integrated unit. Preferably, the auxiliary wing 320 is a bended metal plate latched to the base 340 with the support body 310.

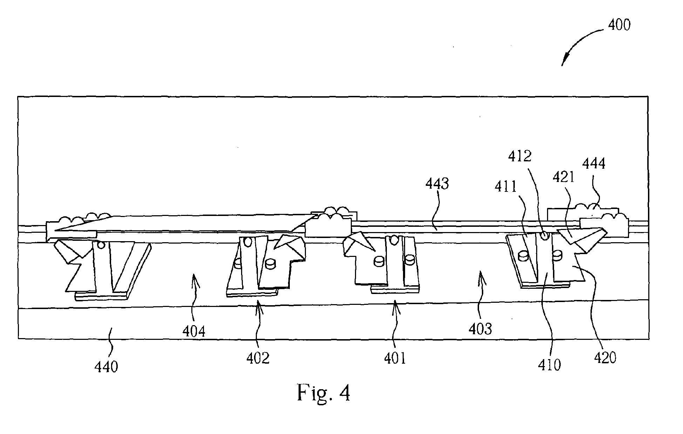

FIGS. 4-7 illustrate the method for transporting a substrate of the present invention. First, as shown in FIG. 4, the substrate transportation equipment 400 includes a base 440, a plurality of first supporting devices 401 disposed on a first location 403 of the base 400, a plurality of second supporting devices 402 disposed on a second location 402 of the base 400, and a working beam 443 including a pair of movable protruding members 444 disposed on the base 400 reciprocating between the first location 403 and the second location 404.

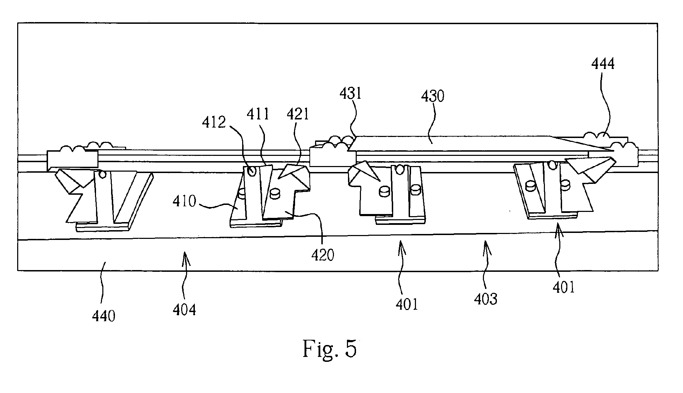

Afterwards, as shown in FIG. 5 the substrate 430 is substantially horizontally placed on the first supporting devices 401. Then the protruding member 444 is elevated so that the protruding member 444 replaces the first supporting devices 401 to support the substrate 430. Please note that the substrate 430 has corners 431.

Both the first supporting device 401 and the second supporting device 402 respectively include a support body 410 and an auxiliary wing 420. The support body 410 is useful in supporting the substrate 430 and the auxiliary wing 420 is useful in supporting the corners 431 of the substrate 430, so that the substrate 430 may be substantially horizontally disposed on the supporting device.

The substrate 430 is usually, but not limited to, a bendable article, such as a solar cell. Usually, the support body 410 may include a first top surface 411 so that the substrate 430 may lie on the support body 410 by means of the first top surface 411. Preferably, the support body 410 further includes a cushion 412 made of elastic material, such as a plastic tube, on the first top surface 411.

Similarly, the auxiliary wing 420 may include a second top rim 421 so that the corners 431 of the substrate 430 may lie on the second top rim 421 of the auxiliary wing 420. Also, the auxiliary wing 420 may further include a pad (not shown) on the second top rim 421 to avoid scratching the substrate. The auxiliary wing 420 may be made of materials such as plastics or metal, so that the auxiliary wing 420 can correctly support the corners 431 of the substrate 430.

The auxiliary wing 420 may extend from the support body 410 along the diagonal direction of the substrate 430. In order to allow the auxiliary wing 420 to correctly support the corners 431 of the substrate 430, the second top rim 421 is preferably slightly lower than the first top surface 411. The auxiliary wing 420 may be detachably connected to the support body 410, or the support body 410 and the auxiliary wing 420 may be formed as an integrated unit. Preferably, the auxiliary wing 420 is a bended metal plate latched to the base 440 with the support body 410.

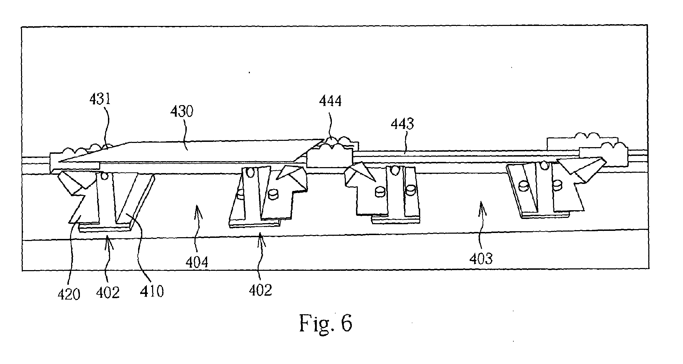

Later, as shown in FIG. 6, the protruding member 444 and the substrate 430 thereon altogether move from the first location 403 to the second location 404 along the working beam 443. The distance between the first location 403 and the second location 404 depends on the dimension of the substrate 430. In general, the shorter the distance, the higher the yield.

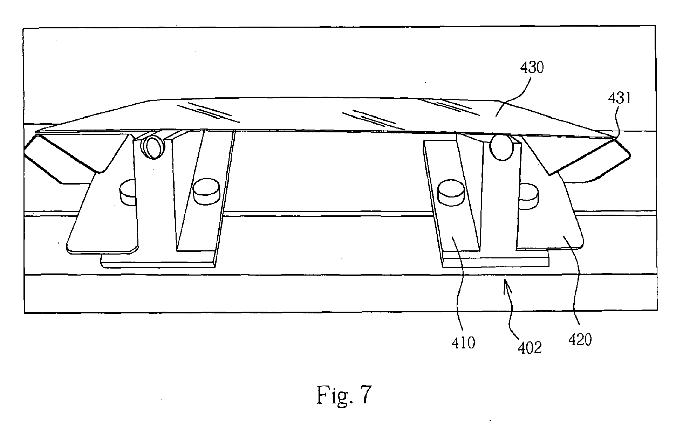

After reaching the second location 404, the protruding member 444 is lowered so that the substrate 430 is off the protruding member 444 and substantially horizontally disposed on the second supporting devices 402. As shown in FIG. 7, because the auxiliary wing 420 elevates the drooping corners 431 of the substrate 430, the substrate 430 is, at this point, substantially horizontally disposed on the supporting device 402 so the collision of the movable protruding member (not shown) with corners 431 of the substrate 430 during its reciprocation can be avoided. Accordingly, the height of the auxiliary wing 420 is preferably between the support body 410 and the protruding member 444. Afterwards the protruding member 444 returns to the first location 403.

All combinations and sub-combinations of the above-described features also belong to the invention.

## Claims

1. A supporting device (200) **characterized by**:
a support body (210) for supporting a substrate (330); and
an auxiliary wing (220) for supporting corners of said substrate (330), so that said substrate (330) is substantially horizontally disposed on said supporting device (200).

2. The supporting device (200) of claim 1, **characterized in that** said substrate (330) comprises a solar cell substrate.

3. The supporting device (200) of claim 1, **characterized in that** said support body (210) comprises a first top surface (211) so that said substrate (330) lies on said first top surface (211).

4. The supporting device (200) of claim 1, **characterized in that** said support body (210) further comprises a cushion (212) on said first top surface (211) for supporting said substrate (330).

5. The supporting device (200) of claim 1, **characterized in that** said auxiliary wing (220) is selected from materials consisting of metal and plastic.

6. The supporting device (200) of claim 1, **characterized in that** said auxiliary wing (220) extends from said support body (210) along the diagonal direction of said substrate (330).

7. The supporting device (200) of claim 1, **characterized in that** said auxiliary wing (220) comprises a second top rim (221) so that the corners of said substrate (330) lie on said second top rim (221).

8. The supporting device (200) of claim 1, **characterized in that** said auxiliary wing (220) further comprises a pad disposed on said second top rim (221) for avoiding scratching said substrate (330).

9. The supporting device (200) of claim 1, **characterized in that** said support body (210) and said auxiliary wing (220) are formed as an integrated unit.

10. The supporting device (200) of claim 1, **characterized in that** said auxiliary wing (220) is a bended metal plate latched to a base with said support body (210).

11. A substrate transportation equipment (300), **characterized by**:
a base (340) comprising a central working beam (343), and a first base surface (341) and a second base surface (342) respectively disposed on both sides of said central working beam (343), wherein said central working beam (343) comprises a reciprocating movable protruding member (344) for transporting a substrate (330); and
a plurality of supporting devices (301) correspondingly disposed on said first base surface (341) and said second base surface (342), wherein each supporting device (301) comprises a support body (310) for supporting said substrate (330) and an auxiliary wing (320) for supporting said substrate (330) so that said substrate (330) is substantially horizontally disposed on said supporting devices (301) to avoid the collision of said movable protruding member (344) with corners of said substrate (330) during its reciprocation.

12. The substrate transportation equipment (300) of claim 11, **characterized in that** said substrate (330) comprises a solar cell substrate.

13. The substrate transportation equipment (300) of claim 11, **characterized in that** said support body (310) comprises a first top surface (311) so that said substrate (330) lies on said first top surface (311).

14. The substrate transportation equipment (300) of claim 11, **characterized in that** said support body (310) further comprises a plastic tube disposed on said first top surface (311) for supporting said substrate (330).

15. The substrate transportation equipment (300) of claim 11, **characterized in that** said auxiliary wing (320) is selected from materials consisting of metal and plastic.

16. The substrate transportation equipment (300) of claim 11, **characterized in that** said auxiliary wing (320) extends from said support body (310).

17. The substrate transportation equipment (300) of claim 11, **characterized in that** said auxiliary wing (320) comprises a second top rim (321) for supporting the corners of said substrate (330).

18. The substrate transportation equipment (300) of claim 17, **characterized in that** said auxiliary wing (320) further comprises a pad disposed on said second top rim (321) to avoid scratching said substrate (330).

19. The substrate transportation equipment (300) of claim 11, **characterized in that** said support body (310) and said auxiliary wing (320) are formed as an integrated unit.

20. The substrate transportation equipment (300) of claim 11, **characterized in that** said auxiliary wing (320) is a bended metal plate latched to said base (340) with said support body (310).

21. A method for transporting a substrate (430), **characterized by**:
providing a substrate transportation equipment (400) comprising a base (440), a plurality of first supporting devices (401) disposed on a first location (403) of said base (440), a plurality of second supporting devices (402) disposed on a second location (404) of said base (440), and a working beam (443), disposed on said base (440), comprising a reciprocating movable protruding member (444) between
said first location (403) and said second location (404); substantially horizontally placing a substrate (430) on said first supporting devices (401);
elevating said protruding member (444) so that said protruding member (444) replaces said first supporting devices (401) to support said substrate (430);
moving said protruding member (444) and said substrate (430) thereon from said first location (403) to said second location (404) along said working beam (443);
lowering said protruding member (444) so that said substrate (430) is off said protruding member (444) and substantially horizontally disposed on said second supporting devices (402); and
returning said protruding member (444) to said first location (403).

22. The method of claim 21, **characterized in that** each said first (401) and second (402) supporting device comprises a support body (410) and an auxiliary wing (420).

23. The method of claim 22, **characterized in that** said support body (410) comprises a first top surface (411) so that the rim of said substrate (430) substantially horizontally lies on said first top surface (411) and said auxiliary wing (420) comprises a second top rim (421) so that the corners of said substrate (43) substantially horizontally lie on said second top rim (421).

24. The method of claim 23, **characterized in that** said first top surface (411) is slightly lower than said second top rim (421).

25. The method of claim 22, **characterized in that** said support body (410) further comprises a cushion (412) on said first top surface (411).

26. The method of claim 22, **characterized in that** said auxiliary wing (420) is made of a plastic material.

27. The method of claim 22, **characterized in that** said auxiliary wing (420) further comprises a pad disposed on said second top rim (421).

28. The method of claim 22, **characterized in that** said auxiliary wing (420) is detachably connected to said support body (410).

29. The method of claim 22, **characterized in that** the height of said auxiliary wing (420) is between that of said support body (410) and said protruding member (444).

30. The method of claim 21, **characterized in that** said substrate (430) comprises a solar cell substrate.

## Amended claims

### Amended claims in accordance with Rule 137(2) EPC.

**1.** A supporting device (200) comprising:
a support body (210) for supporting a substrate (330); and
an auxiliary wing (220) for supporting corners of said substrate (330), so that said substrate (330) is substantially horizontally disposed on said supporting device (200),
**characterized in that** said auxiliary wing (220) extends from said support body (210) along the diagonal direction of said substrate (330).

**2.** The supporting device (200) of claim 1, **characterized in that** said substrate (330) comprises a solar cell substrate.

**3.** The supporting device (200) of claim 1, **characterized in that** said support body (210) comprises a first top surface (211) so that said substrate (330) lies on said first top surface (211).

**4.** The supporting device (200) of claim 1, **characterized in that** said support body (210) further comprises a cushion (212) on said first top surface (211) for supporting said substrate (330).

**5.** The supporting device (200) of claim 1, **characterized in that** said auxiliary wing (220) is selected from materials consisting of metal and plastic.

**6.** The supporting device (200) of claim 1, **characterized in that** said auxiliary wing (220) comprises a second top rim (221) so that the corners of said substrate (330) lie on said second top rim (221).

**7.** The supporting device (200) of claim 1, **characterized in that** said auxiliary wing (220) further comprises a pad disposed on said second top rim (221) for avoiding scratching said substrate (330).

**8.** The supporting device (200) of claim 1, **characterized in that** said support body (210) and said auxiliary wing (220) are formed as an integrated unit.

**9.** The supporting device (200) of claim 1, **characterized in that** said auxiliary wing (220) is a bended metal plate latched to a base with said support body (210).

**10.** A substrate transportation equipment (300), **characterized by**:
a base (340) comprising a central working beam (343), and a first base surface (341) and a second base surface (342) respectively disposed on both sides of said central working beam (343), wherein said central working beam (343) comprises a reciprocating movable protruding member (344) for transporting a substrate (330); and
a plurality of supporting devices (301) correspondingly disposed on said first base surface (341) and said second base surface (342), wherein each supporting device (301) comprises a support body (310) for supporting said substrate (330) and an auxiliary wing (320) for supporting said substrate (330) so that said substrate (330) is substantially horizontally disposed on said supporting devices (301) to avoid the collision of said movable protruding member (344) with corners of said substrate (330) during its reciprocation, wherein said auxiliary wing (220) extends from said support body (210) along the diagonal direction of said substrate (330).

**11.** The substrate transportation equipment (300) of claim 10, **characterized in that** said substrate (330) comprises a solar cell substrate.

**12.** The substrate transportation equipment (300) of claim 10, **characterized in that** said support body (310) comprises a first top surface (311) so that said substrate (330) lies on said first top surface (311).

**13.** The substrate transportation equipment (300) of claim 10, **characterized in that** said support body (310) further comprises a plastic tube disposed on said first top surface (311) for supporting said substrate (330).

**14.** The substrate transportation equipment (300) of claim 10, **characterized in that** said auxiliary wing (320) is selected from materials consisting of metal and plastic.

**15.** The substrate transportation equipment (300) of claim 10, **characterized in that** said auxiliary wing (320) extends from said support body (310).

**16.** The substrate transportation equipment (300) of claim 10, **characterized in that** said auxiliary wing (320) comprises a second top rim (321) for supporting the corners of said substrate (330).

**17.** The substrate transportation equipment (300) of claim 16, **characterized in that** said auxiliary wing (320) further comprises a pad disposed on said second top rim (321) to avoid scratching said substrate (330).

**18.** The substrate transportation equipment (300) of claim 10, **characterized in that** said support body (310) and said auxiliary wing (320) are formed as an integrated unit.

**19.** The substrate transportation equipment (300) of claim 10, **characterized in that** said auxiliary wing (320) is a bended metal plate latched to said base (340) with said support body (310).

**20.** A method for transporting a substrate (430), **characterized by**:
providing a substrate transportation equipment (400) comprising a base (440), a plurality of first supporting devices (401) disposed on a first location (403) of said base (440), a plurality of second supporting devices (402) disposed on a second location (404) of said base (440), and a working beam (443), disposed on said base (440), comprising a reciprocating movable protruding member (444) between said first location (403) and said second location (404);
substantially horizontally placing a substrate (430) on said first supporting devices (401);
elevating said protruding member (444) so that said protruding member (444) replaces said first supporting devices (401) to support said substrate (430);
moving said protruding member (444) and said substrate (430) thereon from said first location (403) to said second location (404) along said working beam (443);
lowering said protruding member (444) so that said substrate (430) is off said protruding member (444) and substantially horizontally disposed on said second supporting devices (402); and
returning said protruding member (444) to said first location (403),
**characterized in that** each said first (401) and second (402) supporting device comprises a support body (410) and an auxiliary wing (420),
and said support body (410) comprises a first top surface (411) so that the rim of said substrate (430) substantially horizontally lies on said first top surface (411) and said auxiliary wing (420) comprises a second top rim (421) extending along the diagonal direction of the substrate (430), so that the corners of said substrate (430) substantially horizontally lie on said second top rim (421).

**21.** The method of claim 20, **characterized in that** said first top surface (411) is slightly lower than said second top rim (421).

**22.** The method of claim 20, **characterized in that** said support body (410) further comprises a cushion (412) on said first top surface (411).

**23.** The method of claim 20, **characterized in that** said auxiliary wing (420) is made of a plastic material.

**24.** The method of claim 20, **characterized in that** said auxiliary wing (420) further comprises a pad disposed on said second top rim (421).

**25.** The method of claim 20, **characterized in that** said auxiliary wing (420) is detachably connected to said support body (410).

**26.** The method of claim 20, **characterized in that** the height of said auxiliary wing (420) is between that of said support body (410) and said protruding member (444).

**27.** The method of claim 20, **characterized in that** said substrate (430) comprises a solar cell substrate.
